# EUROPEAN PATENT APPLICATION

(11) **EP 2 363 958 A1**
(43) Date of publication of application: **07.09.2011**
(21) Application number: 10305218.9
(22) Date of filing: 04.03.2010
(51) Int. Cl.: H03K 19/177, H01H 1/00

(54) **Field programmable gate array**

(71) Applicant: Thomson Licensing, 92130 Issy-les-Moulineaux (FR)
(72) Inventor: Blawat, Meinolf, 30659, Hannover (DE); Kropp, Holger, 30900, Wedemark (DE)
(74) Representative: Schmidt-Uhlig, Thomas

(57) **Abstract**

A field programmable gate array is disclosed, which comprises at least one logic element (2,14,28,30,40) having at least one switching element (8). The switching element (8) comprises a static support element (24) and a movable connecting element (26) for providing a non-volatile electrical connection.

## Description

The present invention relates to a field programmable gate array (FPGA) comprising a logic element having at least one switching element for providing a switchable electrical connection.

A field-programmable gate array (FPGA) is a semiconductor device that can be configured by the customer or the designer "in the field" after manufacturing. FPGAs are programmed using a logic circuit diagram or a source code in a hardware description language (HDL) to specify the functionality of the FPGA. Any logical function that an application specific integrated circuit (ASIC) could perform can be implemented. FPGAs contain programmable logic components called logic blocks. The main building blocks of FPGAs are so called standardized Basic Logic Elements (BLE).

Logic blocks typically comprise a variety of different logic elements that can be configured to perform complex combinational functions, or merely simple logic gates like AND and XOR. In most FPGAs the logic blocks also include memory elements, which may be simple flip-flops or more complex blocks of memory.

A hierarchy of reconfigurable interconnects allows the blocks to be wired together, comparable to a one-chip programmable breadboard. The interconnection between the BLEs is provided by so called Configurable Routing Channels (CRC). Each FPGA device consists of a huge amount of BLEs, which can be arbitrarily connected via the very flexible CRCs, thus forming complex sequential or combinatorial logical networks.

In common FPGAs the BLEs are built using common Complementary Metal Oxide Semiconductor (CMOS) circuit elements, comprising for example Metal Oxide Semiconductor Field Effect Transistors (MOSFETs). Since MOSFETs are volatile, i.e. they lose their status after power is switched off, such FPGAs have to be programmed every time when switched on. However, CMOS technology is approaching its scaling limits. Further, due to the fact that MOSFETs are used as switching elements in typical CMOS circuitry, the signal speed is comparably slow and leakage of current occurs in static mode.

Accordingly, it is an object of the present invention to provide a field programmable gate array that is improved with respect to the drawbacks know from prior art.

The problem is solved by the subject matter of claim 1. Advantageous embodiments are subject matter of the dependent claims.

A field programmable gate array according to the invention comprises at least one logic element for providing a logic function, wherein the logic element has at least one switching element. The switching element comprises a static support element and a movable connecting element, which provides a nonvolatile electrical connection.

Since the switching element provides a nonvolatile electrical connection, the field programmable gate array remains in its status even if the power supply is switched off. Consequently, the device, i.e. the field programmable gate array, will immediately resume processing in case the power supply is switched on again. Further, the device will resume processing exactly in the status in which it has been switched off. This feature is often called "instant-on", because the rather long boot time of modern digital devices is avoided.

Advantageously, the logic element is one of an AND-, OR-, NOT-, NAND-, NOR-, XOR-, XNOR-element and a multiplexer. This means that the switching element is included in a logic gate. The aforementioned logic gates are building blocks for more complex circuitry, like e.g. a flip-flop. Advantageously, these building blocks are of a nonvolatile nature. Therefore, more complex logical blocks or gates that are based on the aforementioned logic gates provide an "instant-on" characteristic. No further adaptation like integration of memory cells or the like is necessary

It is further advantageous if the logic element comprises two alternately working switching elements. By applying two alternately working switching elements, the basic functionality of a non-volatile multiplexer is provided.

Alternatively, the switching element comprises a static support element that is connected to an output of the logic element and a movable connecting element adapted to establish a connection of the static support element to either the first input or a second input of said logical element. In other words, the aforementioned two alternately working switching elements are replaced by one switching element capable of providing an electrical connection to either a first or a second input. Due to the fact that only one movable connecting element is employed, the number of moving parts is advantageously reduced.

A further advantageous field programmable gate array comprises at least one switching element acting as a storage cell. The open/closed-state of said switching element is used to store bit information. Since the switching element provides a nonvolatile electrical connection, a nonvolatile storage cell is thus provided. It is further advantageous if a look-up table comprises at least one such storage cell.

Advantageously, the field programmable gate array comprises a basic logic element that is composed of at least one storage cell, a flip flop and a multiplexer, wherein the aforementioned elements are realized using said non-volatile switching elements.

An advantageous field programmable gate array comprises a switching element that is realized based on nanotube technology, preferably carbon nanotube technology. Appropriate switching elements will be referred to as carbon nanotube switches.

Preferably, the switching element comprises a telescoping nanotube, preferably a telescoping carbon nanotube. Such a telescoping nanotube comprises a movable core-nanotube and a static support-nanotube, wherein the core-nanotube surrounds the static support-nanotube or vice versa. Preferably, at least a segment of the core-nanotube and the support-nanotube form part of a conductive path that a switchable current takes through the switching element.

Signal speed of electrical signals is very fast in carbon nanotube switching elements. Consequently, a field programmable gate array based on such a switching element shows a high processing performance. The drawbacks known from CMOS-technology, like e.g. the comparably low signal transfer speed due to the charge carrier characteristic of solid state semiconductors like e.g. MOSFETs, is overcome. A further advantage is given by the fact that a carbon-nanotube switch disconnects the input and output terminal galvanically. Thereby, in contrast to common MOSFET-technology, the occurrence of leak currents is avoided. Consequently, a field programmable gate array based on carbon-nanotube switching elements has a very small static power dissipation. Consequently, it is perfectly suited for mobile-applications.

Advantageously, switching elements based on nanotube switches consist of less circuit elements compared to common CMOS-technology. This means that a field programmable gate array comprising nanotube switching elements is very compact and, therefore, occupies less chip area. At the same time the application of nanotube switches has only little effect on a chip production line. Nanotube switches can be fabricated using manufacturing tools known from MOEFET-technology. Therefore, a very densely packed electrical circuitry that can be fabricated in an economical way is provided.

For a better understanding the invention shall now be explained in more detail in the following description with reference to the figures. It is understood that the invention is not limited to this exemplary embodiment and that specified features can also expediently be combined and/or modified without departing from the scope of the present invention as defined in the appended claims. In the figures:
- Fig. 1: shows a schematic sketch of an inverter,
- Fig. 2: shows the corresponding circuit symbol,
- Fig. 3: shows a circuit diagram of said inverter, as it is known from prior art,
- Fig. 4: shows a multiplexer,
- Fig. 5: shows a telescoping nanotube in an open state,
- Fig. 6: shows a telescoping nanotube in a closed state,
- Fig. 7: shows an alternative multiplexer,
- Fig. 8: shows a schematic sketch of a logic AND-element,
- Fig. 9: shows a corresponding circuit symbol,
- Fig. 10: shows a schematic sketch of a logic D-Flip-Flopelement,
- Fig. 11: shows the corresponding circuit symbol,
- Fig. 12: shows an address line decoder,
- Fig. 13: shows a corresponding circuit symbol,
- Fig. 14: shows an assembly of storage cells,
- Fig. 15: shows a corresponding circuit symbol,
- Fig. 16: shows a circuit symbol for a look up table, and
- Fig. 17: shows a schematic view of a basic logic element of a field programmable gate array.

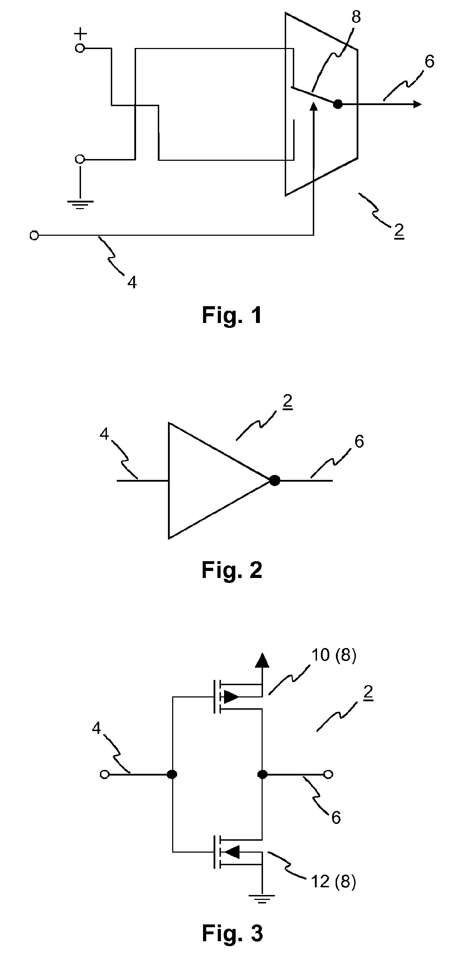

Fig. 1 shows a schematic sketch of an inverter 2. A corresponding circuit symbol is depicted in Fig. 2. The inverter 2 is connected to an input line 4 and an output line 6. The input line 4 acts as a select line for the switching element 8 included in the inverter 2. Fig. 3 shows an inverter 2 that is realized using conventional CMOS-technology. The switching element 8 is realized by a p-type MOSFET 10 and an n-type MOSFET 12. Both of the MOSFETs 10, 12 are connected to the same control voltage. Due to this fact the transistors work complementary, i.e. while one of the transistors is locking the other one is conductive.

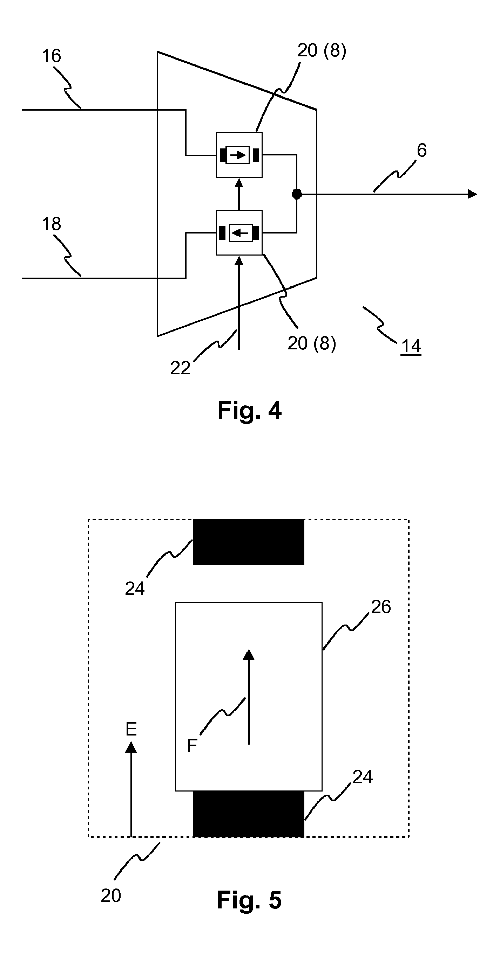

Fig. 4 shows a multiplexer 14 according to a first embodiment of the invention. The multiplexer 14 is connected to a first and a second input line 16, 18 as well as to an output line 6. The multiplexer 14 comprises two telescoping carbon nanotubes 20 acting as a switching element 8. Of course, nanotube switching elements different from carbon nanotubes can be applied in the same way. The two telescoping carbon nanotubes 20 work in phase opposition, in other words, one of the two telescoping carbon nanotubes 20 is open while the other one is closed.

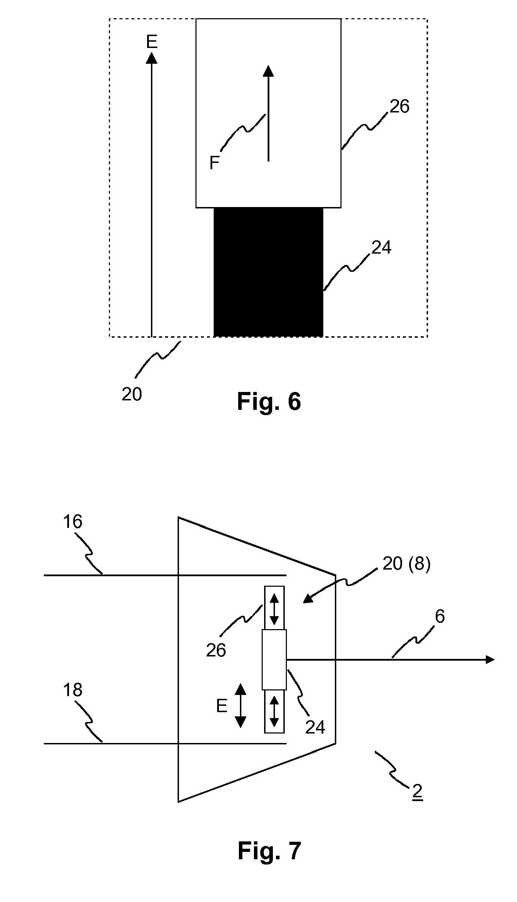

Depending on the voltage that is applied to the switching element 8 by the select line 22, a varying electrical field E is applied. The varying electrical field E causes the switching process, which is depicted in Figs. 5 and 6. Fig. 5 illustrating the telescoping carbon nanotube 20 in an open state, whereas Fig. 6 shows the telescoping carbon nanotube 20 in a closed state. The telescoping carbon nanotube 20 comprises a static support element 24 and a movable connecting element 26. Both elements 24, 26 are realized by carbon nanotubes, wherein the connecting element 26 radially surrounds the static support element. The latter is galvanically divided into a first and a second electrode. A first electrode is depicted in the lower part of Fig. 5, while the upper part of the static support element 24 is depicted in the upper part of Fig. 5. By applying a voltage between the two parts of the static support element 24, an electric field E is generated. Said electric field E leads to a force F on the movable connecting element 26, causing it to move in a direction towards the opposite part of the static support element 24 in case of an open state of the telescoping carbon nanotube 20. In a closed state of the telescoping carbon nanotube 20, the movable connecting element 26 overlaps both parts of the static support element 24, thereby providing an electrical path for a switchable current flowing between the two respective parts of the static support element 24.

Fig. 7 shows an alternative embodiment of an inverter 2. Instead of two telescoping carbon nanotubes 20, only one telescoping carbon nanotube 20 is used as a switching element 8. The telescoping carbon nanotube 20 has three switching positions, the first one at equilibrium, as it is depicted in Fig. 7. In a second position the movable connecting element 26 is in electrical contact with the first input line 16, whereas in a third position the movable connecting element 26 is in electrical contact with the second input line 18. Contrary to the telescoping carbon nanotube 20 shown in Figs. 5 and 6, the telescoping carbon nanotube 20 according to Fig. 7 comprises a static support element 24 that radially surrounds the movable connecting element 26. The latter projects entirely through the static support element 24 in a longitudinal direction. As already explained with reference to Figs. 5 and 6, the movable connecting element 26 is switched, i.e. moved with respect to the static support element 24, by applying and adequate voltage between the static support element 24 and the respective input line 16, 18. The electric field E that is generated due to this measure causes a force F, which moves the movable connecting element 26.

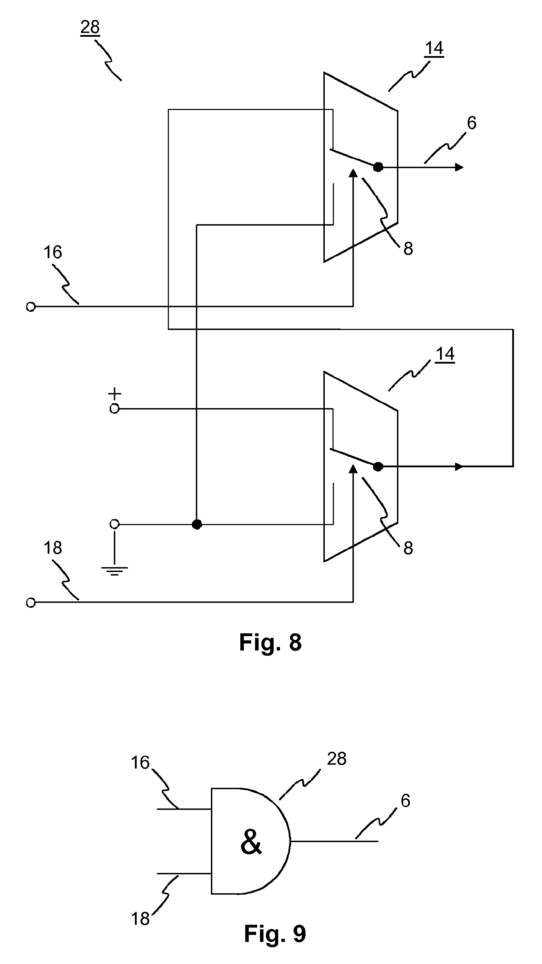

Fig. 8 shows a schematic sketch of a logic AND-element 28, while Fig. 9 shows the corresponding circuit symbol. The AND-element 28 comprises two multiplexers 14. Each multiplexer 14 comprises a switching element 8 that is realized using a telescoping carbon nanotube 20, comparable to the telescoping carbon nanotubes 20 depicted in Figs. 4 and 7. For the sake of clarity only a schematic sketch of the multiplexers 14 is depicted in Fig. 8.

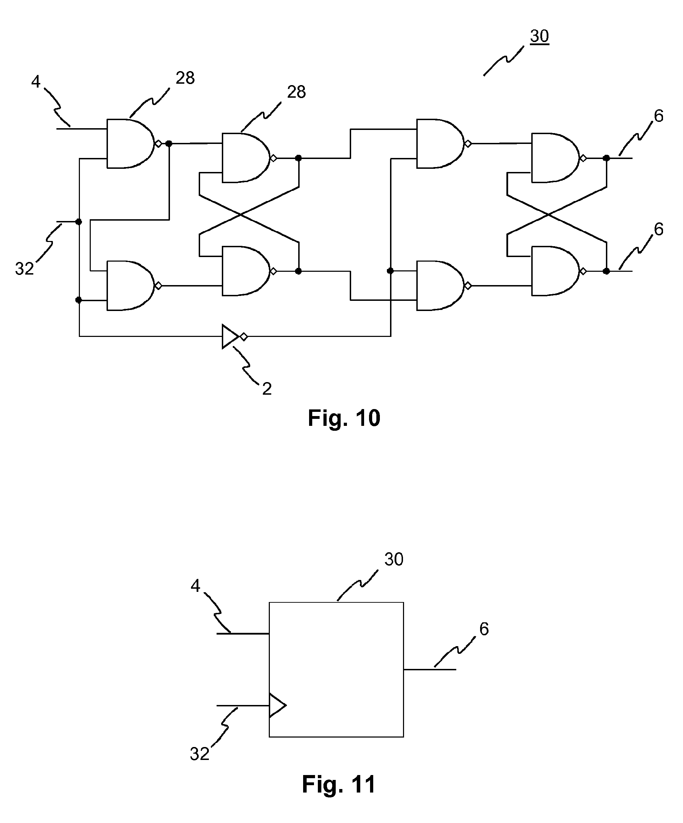

Fig. 10 shows a schematic sketch of a logic D-Flip-Flop element 30 comprising a plurality of AND-elements 28 as well as an inverter 2. For the sake of clarity, only some AND-elements 28 are provided with reference numerals. The D-Flip-Flop 30 is connected to an input line 4 and an output line 6, further, it is connected to a clock line 32. The corresponding circuit symbol of the D-Flip-Flop 30 is shown in Fig. 11. Each of the logic gates included in the depicted D-Flip-Flop 30, i.e. the AND-elements 28 and the inverter 2, comprise switching elements based on carbon nanotube switches. It is understood that other types of Flip-Flops, which are different from the depicted D-Flip-Flop 30, may be constructed using logic gates comprising switching elements based on carbon nanotubes.

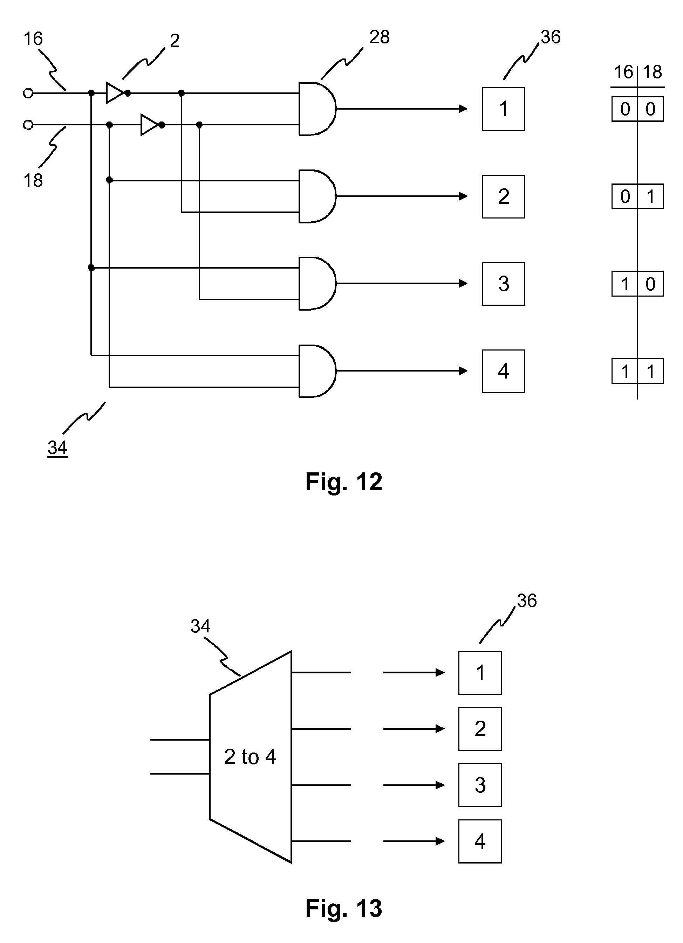

Fig. 12 shows an address line decoder 34. Fig. 13 shows the corresponding circuit symbol. The address line decoder 34 comprises a plurality of AND-elements 28 and two inverters 2. For the sake of clarity only some are provided with reference numerals. A first and a second input line 16, 18 are connected to the address line decoder 34. Depending on the bit status of the respective input line 16, 18, incoming information is stored in one of the storage cells 36 indicated by arabic numbers 1 to 4. The bit status routing the signal to one of the storage cells 36 is indicated by the table depicted right to the respective storage cell. For example, in case the first input line 16 is "1" and the second input line 18 is "0", the signal is routed to storage cell number 3.

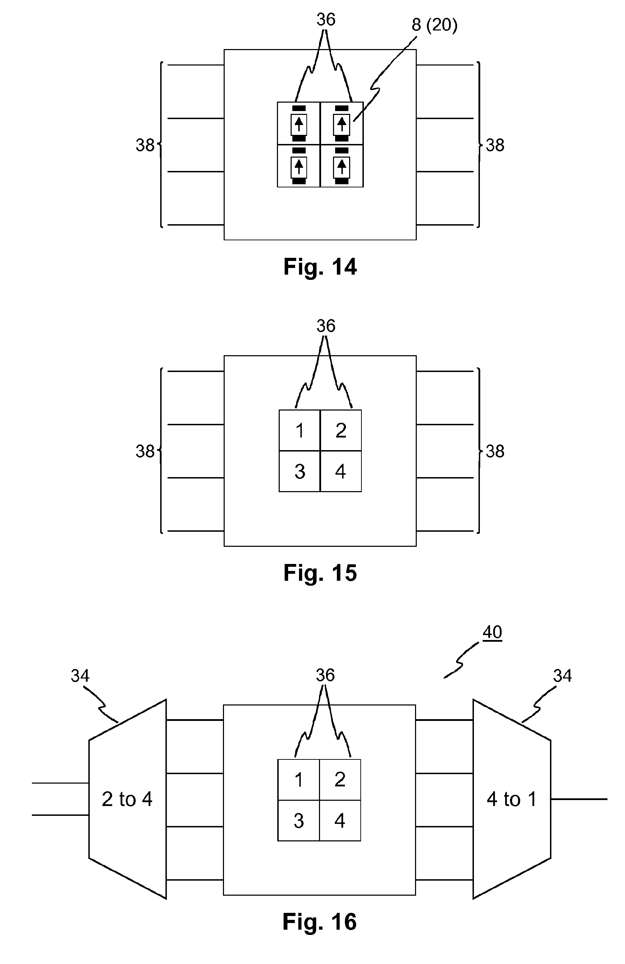

Fig. 14 shows a plurality of storage cells 36, each one comprising a switching element 8 based on a carbon nanotube switch 20. Bit information is stored in the respective storage cells 36 as an open/closed-state of the respective switching element 8. Again, a telescoping carbon nanotube 20 is used as a switching element. A plurality of address lines 38 is connected to the assembly of storage cells 36. Fig. 15 shows a schematic sketch representing the assembly of storage cells, where again the storage cells are indicated by arabic numbers.

Fig. 16 shows a circuit symbol for a look up table 40, comprising a two to four and a four to one address line decoder 34 as well as an assembly of storage cells 36.

Each of the aforementioned logic gates, in particular the multiplexer 18 (see Figs. 2 and 4), the AND-element 28 (see Fig. 5) and the D-Flip-Flop 30 (see Fig. 6) comprise at least one switching element 8 that is realized using a nanotube switch, i.e. a telescoping nanotube 20. Due to this fact, all of the switching elements 8 provide a non-volatile electrical connection. Consequently, all of the aforementioned logic gates provide an "instant-on"-characteristic.

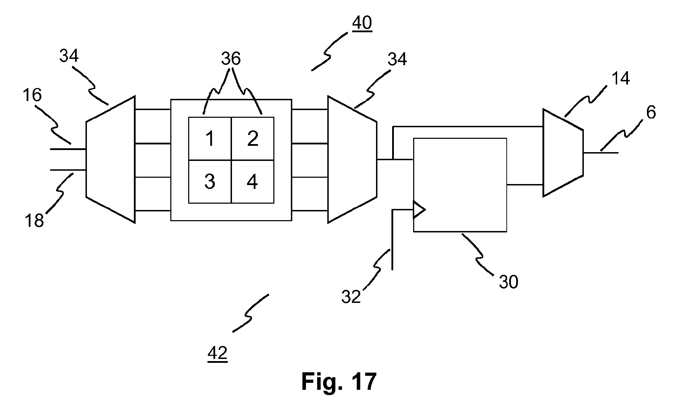

Fig. 17 shows a basic logic element 42 included in a field programmable gate array. This basic logic element 42 comprises a look up table 40, a D-Flip-Flop 30 and a multiplexer 14. The basic logic element 42 is connected to first and second input lines 16, 18 and an output line 6. Further, it is connected to a clock line 32. As the logic gates included in the basic logic element 42, i.e. the multiplexer 14, the D-Flip-Flop 30 and the look up table 40, have telescoping carbon nanotubes 20 as switching elements 8, the basic logic element 42 is non-volatile.

## Claims

1. Field programmable gate array comprising at least one logic element (2,14,28,30,40) for providing a logical function, the logic element (2,14,28,30,40) having at least one switching element (8), **characterized in that** said at least one switching element (8) comprises a static support element (24) and a movable connecting element (26) providing a non-volatile electrical connection.

2. Field programmable gate array according to claim 1, **wherein** the logic element (2,14,28,30,40) is one of AND-,OR, NOT-, NAND-, NOR-, XOR-, XNOR-element and a multiplexer.

3. Field programmable gate array according to claims 1 or 2, **wherein** the logic element (2,14,28,30,40) comprises two alternately working switching elements (8).

4. Field programmable gate array according to claims 1 or 2, **wherein** the static support element (24) is connected to an output of the logic element (2,14,28,30,40) and the moveable connecting element (26) is adapted to establish a connection of the static support element (24) to either a first input (16) or a second input (18) of the logic element (2,14,28,30,40).

5. Field programmable gate array according to one of claims 1 to 4, **wherein** the field programmable gate array further comprises at least one switching element acting as a storage cell (36), wherein bit information is stored in the form of an open/closed-state of the respective switching element (8) .

6. Field programmable gate array according to claim 5, **wherein** multiple storage cells (36) are combined to a look-up table (40).

7. Field programmable gate array according to one of claims 1 to 6, **having** a basic logic element (42) composed of at least one storage cell (36), one flip-flop (30) and one multiplexer (14) realized with said switching elements (8).

8. Field programmable gate array according to one of claims 1 to 7, **wherein** the switching element (8) comprises a telescoping nanotube (20).

9. Field programmable gate array according to claim 8, **wherein** at least one segment of the static support element (24) and the movable connecting element (26) form part of a conductive path that a switchable current takes through the switching element (8).
